# EUROPEAN PATENT APPLICATION

(11) **EP 4 730 037 A1**
(43) Date of publication of application: **22.04.2026**
(21) Application number: 24838601.3
(22) Date of filing: 27.06.2024
(51) Int. Cl.: G03F 7/20

(54) **UNIFORM EXPOSURE APPARATUS FOR FLEXIBLE PRINTING PLATE**

(30) Priority: 11.07.2023 CN 202310843549
(71) Applicant: Ting, So Yung Warren, Shenzhen, Guangdong 518100 (CN)
(72) Inventor: TING, So Yung Warren, Shenzhen, Guangdong 518100 (CN); LIU, Houlai, Shenzhen, Guangdong 518100 (CN)
(74) Representative: Metida
(86) International application number: PCT/CN2024/101895
(87) International publication number: WO 2025/011345

(57) **Abstract**

The present disclosure relates to the technical field of exposure equipment, and in particular, to a Uniform Exposure apparatus for flexible printing plate. The Uniform Exposure apparatus for flexible printing plate includes: a base, the base including a housing and a storage cavity, the housing covering the storage cavity; an exposure roller, the exposure roller being disposed in the storage cavity, two ends of the exposure roller being rotatably connected to two opposite inner sidewalls of the housing respectively, and the flexible printing plate being wound and laid on the surface of the exposure roller; a roller driving mechanism, the roller driving mechanism being installed in the storage cavity, an output end of the roller driving mechanism being assembled with one end of the exposure roller, and the roller driving mechanism being used to drive the exposure roller to rotate; a positioning mechanism, the positioning mechanism being rotatably installed in the storage cavity, and one side of the positioning mechanism being pressed against the surface of the flexible printing plate; an ultraviolet lamp, the ultraviolet lamp being installed on one side of the exposure roller, and the ultraviolet lamp being aligned with the exposure roller. The device can improve the overall exposure quality of the flexible printing plate.

## Description

### TECHNICAL FIELD

The present disclosure relates to the technical field of exposure equipment, and in particular, to a Uniform Exposure apparatus for flexible printing plate.

### BACKGROUND

Flexographic printing is a type of relief printing process, also known as flexography. It uniformly coats a certain thickness of ink layer on the image-text part of the printing plate through anilox rollers, and under the pressure of the impression cylinder, transfers the ink layer of the image-text part to the surface of the substrate to form clear images and texts.

Flexible printing plates are generally exposed to ultraviolet light. The transparent parts transmit ultraviolet light, and the initiator in the photosensitive elastomer decomposes into free radicals, initiating the reaction of cross linkable monomers for curing; the areas not transmitting ultraviolet light cannot undergo crosslinking reactions. Utilizing the difference in their solubility in the developing solution, the relief image containing text and patterns is obtained by rinsing and developing. After development, the plate material also needs to be dried, desensitized, and post-exposed to ensure complete polymerization of the photosensitive layer, thereby forming a prepared flexible printing plate. Subsequently, the prepared flexible printing plate is fixed on the roller of the flexographic printing machine, and printing can be prepared.

The exposure quality of flexible printing plates is affected by exposure time and exposure temperature. Flexible printing plates of different thicknesses have corresponding exposure time ranges or exposure temperature ranges. In the prior art, during the exposure process of flexible printing plates, the flexible printing plate is first placed flat on the top surface of a transparent glass plate, and two sets of movable ultraviolet lamps above and below are used to expose the flexible printing plate. The following problems exist:
1. When the movable ultraviolet lamp prints on the flexible printing plate, the ultraviolet lamp passes over the flexible printing plate progressively. The first exposure part of the ultraviolet lamp performs the first exposure on the input end of the flexible printing plate. When the ultraviolet lamp completely enters the flexible printing plate, the second exposure part of the ultraviolet lamp performs the second exposure on the input end of the flexible printing plate. When the ultraviolet lamp returns, the first exposure part and the second exposure part of the ultraviolet lamp then perform the third exposure and fourth exposure on the ultraviolet lamp. As a result, the exposure temperature and exposure time of the input end part of the flexible printing plate are much higher than those of other parts of the flexible printing plate, which in turn leads to inconsistent effects of the text and patterns on different parts of the flexible printing plate, and the overall exposure quality of the flexible printing plate is poor;
2. The transparent glass plate provides support for the flexible printing plate. The upper ultraviolet lamp directly irradiates the top surface of the flexible printing plate, and the lower ultraviolet lamp first irradiates the bottom of the glass plate, and then the ultraviolet light passes through the glass plate to irradiate the bottom surface of the flexible printing plate. That is, when irradiating the bottom of the flexible printing plate, the ultraviolet light passes through different media. The ultraviolet light is refracted to a certain extent by the transparent glass plate, resulting in the light intensity irradiating the bottom of the flexible printing plate being weaker than that irradiating the top of the flexible printing plate. In addition, the heat transfer capacity of the glass plate is not as good as the temperature when the ultraviolet lamp directly irradiates the top surface of the flexible printing plate, resulting in fluctuations in the exposure temperature and exposure time between the top and bottom of the flexible printing plate. This also leads to inconsistent effects of the text and patterns on different parts of the flexible printing plate, and the overall exposure quality of the flexible printing plate is poor.

### SUMMARY

In order to improve the overall exposure quality of the flexible printing plate, the present disclosure provides a Uniform Exposure apparatus for flexible printing plate.

The Uniform Exposure apparatus for flexible printing plate provided by the present disclosure adopts the following technical scheme:
A Uniform Exposure apparatus for flexible printing plate, comprising:
a base, including a housing and a storage cavity, the housing covering the storage cavity;
an exposure roller, being disposed in the storage cavity, two ends of the exposure roller being rotatably connected to two opposite inner sidewalls of the housing respectively, and the flexible printing plate being wound and laid on the surface of the exposure roller;
a roller driving mechanism, being installed in the storage cavity, an output end of the roller driving mechanism being assembled with one end of the exposure roller, and the roller driving mechanism being used to drive the exposure roller to rotate;
a positioning mechanism, being rotatably installed in the storage cavity, and one side of the positioning mechanism being pressed against the surface of the flexible printing plate;
an ultraviolet lamp, being installed on one side of the exposure roller, and the ultraviolet lamp being aligned with the exposure roller.

By adopting the above technical scheme, the flexible printing plate is fixed on the surface of the exposure roller through the positioning mechanism. Under the drive of the roller driving mechanism, the exposure roller can rotate, thereby driving the flexible printing plate to move circumferentially. At the same time, the ultraviolet lamp performs progressive exposure on the flexible printing plate. Compared with the prior art, the present disclosure adopts a single-variable exposure method to perform one-way exposure on the flexible printing plate, omits the glass plate, and reduces the adverse effects of light environments of different media on the flexible printing plate. The present disclosure achieves dynamic balance through the circumferential movement of the flexible printing plate, that is, the cooperation between the static ultraviolet lamp and the dynamic flexible printing plate, so that each part of the flexible printing plate can be uniformly exposed, and the situation that the exposure time of the flexible printing plate is different due to the plane reciprocating movement of the ultraviolet lamp is reduced, thereby achieving the purpose of improving the exposure quality of the flexible printing plate.

In an embodiment of the present disclosure, an air exhaust part is disposed on the housing near the lower part of the exposure roller.

By adopting the above technical scheme, the air exhaust part is disposed on the housing near the lower part of the exposure roller. When the ultraviolet lamp irradiates the flexible printing plate, heat can be exhausted out of the housing, so that the temperature in the storage cavity is controlled within a specified range value, the difference in local ambient temperature caused by different working durations of the ultraviolet lamp is reduced, and the temperature of the working environment of the flexible printing plate can be kept approximately constant, thereby reducing the inconsistency of the exposure temperature of the flexible printing plates irradiated successively, which is conducive to ensuring the overall exposure quality of the flexible printing plate.

In an embodiment of the present disclosure, the air exhaust part includes an air exhaust plate, an air exhaust filter plate and an air exhaust mechanism. The air exhaust plate is detachably embedded on the housing near the lower part of the exposure roller. The air exhaust filter plate is installed on one side of the air exhaust plate close to the center of the storage cavity. The air exhaust mechanism is fixed in the storage cavity, and the air exhaust mechanism is used to exhaust the waste gas inside the storage cavity.

By adopting the above technical scheme, under the action of the air exhaust mechanism, the waste gas inside the storage cavity can be quickly exhausted out of the housing. The air exhaust filter plate is installed on one side of the air exhaust plate close to the center of the storage cavity, which can filter the waste gas, thereby reducing the pollution of the waste gas to the external environment and improving the operational safety of the working environment.

In an embodiment of the present disclosure, the housing includes a top plate, a first air deflector, a second air deflector and a bottom plate. One side of the first air deflector is fixed to the top plate, and the other side is fixed to the second air deflector. One side of the second air deflector away from the first air deflector is fixed to the bottom plate. Wherein, the first air deflector is arranged obliquely downward from the top plate to the second air deflector, the second air deflector is arranged obliquely from the first air deflector to the bottom plate toward the side close to the center of the storage cavity, and a triangular air return cavity is formed between the first air deflector and the second air deflector.

By adopting the above technical scheme, when the ultraviolet lamp irradiates the flexible printing plate, a large amount of heat is generated, making the air around the exposure roller hot, and the hot air rises. In the process of the air exhaust mechanism blowing the hot air out of the housing, the hot air bypasses the triangular air return cavity and then is exhausted from the air exhaust plate, so that there will be no sudden cooling or sudden heating around the exposure roller, which helps to keep the temperature of the working environment of the flexible printing plate approximately constant.

In an embodiment of the present disclosure, a cooling mechanism is disposed on one side of the ultraviolet lamp away from the exposure roller.

By adopting the above technical scheme, under the operation of the cooling mechanism, the ultraviolet lamp can be cooled, the overheating phenomenon of the ultraviolet lamp caused by too long working time is reduced, the ultraviolet lamp emits an approximately constant temperature, which helps to ensure the exposure quality of the flexible printing plate, and at the same time, helps to prolong the service life of the ultraviolet lamp.

In an embodiment of the present disclosure, a mounting base frame is fixed in the storage cavity, a suction air rod is fixed on the mounting base frame, a receiving groove is formed through the central axis of the exposure roller, the suction air rod is inserted in the receiving groove, a suction starting component is disposed in the storage cavity, and an output end of the suction starting component is assembled with one end of the suction air rod.

By adopting the above technical scheme, the suction starting component extracts the gas in the suction air rod. On the one hand, a negative pressure is formed in the middle of the exposure roller, so that the flexible printing plate can be stably attached to the surface of the exposure roller, thereby reducing the positional deviation of the flexible printing plate during the rotation of the exposure roller and helping to improve the imaging quality of the printing plate. On the other hand, the gas in the suction air rod has a certain temperature, which helps to regulate the temperature difference between the front and back sides of the flexible printing plate during exposure, and is conducive to ensuring the overall exposure quality of the flexible printing plate.

In an embodiment of the present disclosure, a horn-shaped lampshade is disposed outside the ultraviolet lamp, and the opening direction of the lampshade faces the exposure roller.

By adopting the above technical scheme, a horn-shaped lampshade is disposed outside the ultraviolet lamp. The lampshade can play the role of concentrating light and temperature, so that the ultraviolet light emitted by the ultraviolet lamp can be well irradiated to the flexible printing plate wound on the surface of the exposure roller. In addition, the ultraviolet light irradiated on the inner wall of the lampshade is reflected to the surface of the flexible printing plate, further supplementing the light intensity to ensure the imaging quality of the flexible printing plate.

In an embodiment of the present disclosure, an air blowing mechanism is disposed on the mounting base frame, the air blowing mechanism is distributed at the bottom of the exposure roller, and the output end of the air blowing mechanism is aligned with the outer wall of the exposure roller.

By adopting the above technical scheme, under the action of the air blowing mechanism, on the one hand, the flexible printing plate during exposure can be cooled, and on the other hand, the hot air can be blown upward. Under the cooperation of the first air deflector and the second air deflector, the duration of the hot air in the triangular air return cavity is prolonged, so that there will be no sudden cooling or sudden heating around the exposure roller, which helps to keep the temperature of the working environment of the flexible printing plate approximately constant, so as to ensure the imaging quality of the flexible printing plate.

In an embodiment of the present disclosure, the roller driving mechanism includes a power component and a deviation correcting member. The power component is installed on the mounting base frame, the power component serves as a power source to drive the exposure roller to rotate, the deviation correcting member is rotatably connected to one side of the mounting base frame close to the power component, and the deviation correcting member is used to correct the rotation trajectory of the exposure roller.

By adopting the above technical scheme, the power component serves as a power source to drive the exposure roller to rotate. Under the action of the deviation correcting member, the rotation trajectory of the exposure roller can be corrected, so that the exposure roller keeps moving on the same circumference, thereby driving the displacement of the flexible printing plate and realizing the point-by-point and line-by-line exposure of the flexible printing plate by the ultraviolet lamp.

In an embodiment of the present disclosure, a temperature sensor is disposed on the mounting base frame.

By adopting the above technical scheme, the temperature sensor has high-precision, high-reliability and high-sensitivity temperature sensing capabilities. It can convert the ambient temperature signal into an electrical signal for output, and feed the electrical signal back to the power component. The power component controls the rotation of the exposure roller, thereby realizing automatic temperature adjustment, so that the flexible printing plate is always exposed within a specified temperature range, and the exposure quality is ensured.

In summary, the present disclosure includes at least one of the following beneficial technical effects:
1. Compared with the prior art, the present disclosure adopts a single-variable exposure method to perform one-way exposure on the flexible printing plate, omits the glass plate, and reduces the adverse effects of light environments of different media on the flexible printing plate. The present disclosure achieves dynamic balance through the circumferential movement of the flexible printing plate, that is, the cooperation between the static ultraviolet lamp and the dynamic flexible printing plate, so that each part of the flexible printing plate can be uniformly exposed, and the situation that the exposure time of the flexible printing plate is different due to the plane reciprocating movement of the ultraviolet lamp is reduced, thereby achieving the purpose of improving the exposure quality of the flexible printing plate;
2. In the process of the air exhaust mechanism blowing the hot air out of the housing, the hot air bypasses the triangular air return cavity and then is exhausted from the air exhaust plate, so that there will be no sudden cooling or sudden heating around the exposure roller, which helps to keep the temperature of the working environment of the flexible printing plate approximately constant;
3. The suction starting component extracts the gas in the suction air rod. On the one hand, a negative pressure is formed in the middle of the exposure roller, so that the flexible printing plate can be stably attached to the surface of the exposure roller, thereby reducing the positional deviation of the flexible printing plate during the rotation of the exposure roller and helping to improve the imaging quality of the printing plate. On the other hand, the gas in the suction air rod has a certain temperature, which helps to regulate the temperature difference between the front and back sides of the flexible printing plate during exposure, and is conducive to ensuring the overall exposure quality of the flexible printing plate.

### BRIEF DESCRIPTION OF DRAWINGS

FIG. 1 is a schematic view of the overall structure of the exposure device in the embodiment of the present disclosure.
FIG. 2 is a partial cross-sectional view of the exposure device in the embodiment of the present disclosure.
FIG. 3 is another schematic view of FIG. 2.
FIG. 4 is a schematic view of the cooperation between the ultraviolet lamp and the exposure roller in the embodiment of the present disclosure.
FIG. 5 is a schematic structural diagram of the ultraviolet lamp in the embodiment of the present disclosure.
FIG. 6 is a schematic view of the cooperation between the suction starting component and the exposure roller in the embodiment of the present disclosure.
FIG. 7 is an enlarged view of A in FIG. 6.
FIG. 8 is a schematic view of the cooperation between the suction air rod and the exposure roller in the embodiment of the present disclosure.

Reference numerals illustrate: 11, housing; 111, top plate; 112, first side plate; 113, second side plate; 114, first air deflector; 115, second air deflector; 116, bottom plate; 117, triangular air return cavity; 12, storage cavity; 13, mounting base frame; 131, bracket; 14, suction air rod; 141, suction hole; 15, suction starting component; 151, suction air pump; 152, suction air pipe; 16, control panel; 17, control button; 2, exposure roller; 21, central axis; 211, ventilation hole; 212, receiving groove; 22, roller body; 221, ventilation groove; 312, second pulley; 313, transmission belt; 314, transmission motor; 32, deviation correcting member; 321, deviation correcting support; 322, deviation correcting wheel; 4, positioning mechanism; 41, positioning rotating plate; 42, torsion spring; 43, rotating shaft; 5, ultraviolet lamp; 51, lamp holder; 52, lamp panel; 53, lampshade; 54, cooling mechanism; 61, air exhaust plate; 62, air exhaust filter plate; 63, air exhaust mechanism; 7, air blowing mechanism; 8, temperature sensor.

### DESCRIPTION OF EMBODIMENTS

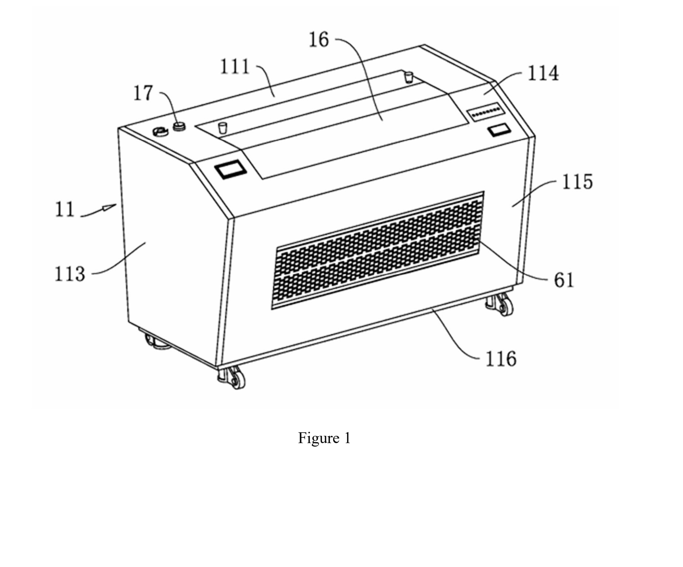

The present disclosure will be further described in detail below with reference to FIGS. 1-8.

The embodiment of the present disclosure discloses a uniform exposure apparatus for flexible printing plate.

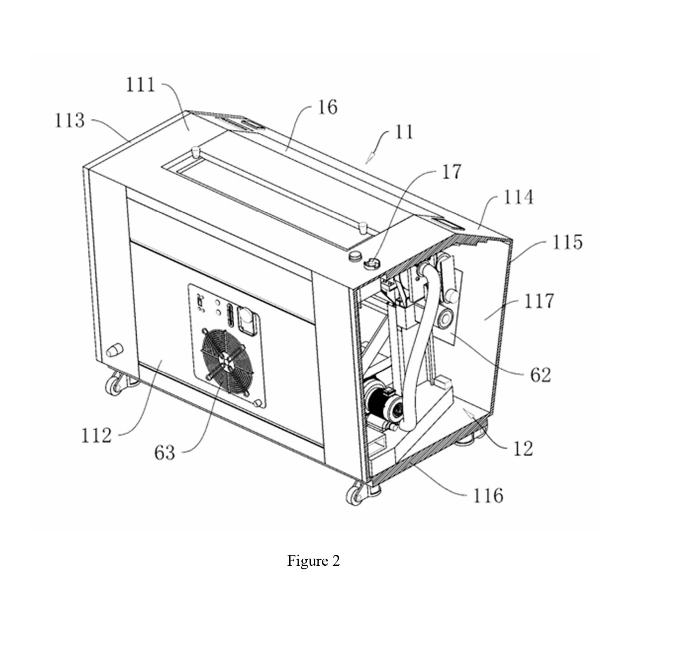

Referring to FIGS. 1 and 2, a Uniform Exposure apparatus for flexible printing plate includes a base. The base includes a housing 11. The housing 11 includes a top plate 111, a first side plate 112, a second side plate 113, a first air deflector 114, a second air deflector 115 and a bottom plate 116. The top surface of the first side plate 112 is fixed to the bottom surface of the top plate 111, and the bottom surface of the first side plate 112 is fixed to the top surface of the bottom plate 116. The first air deflector 114 is fixed to one side of the top plate 111 away from the first side plate 112, and the other side of the first air deflector 114 is fixed to the second air deflector 115. One side of the second air deflector 115 away from the first air deflector 114 is fixed to the bottom plate 116. In the embodiment of the present disclosure, the first air deflector 114 is arranged obliquely downward from the top plate 111 to the second air deflector 115, and the second air deflector 115 is arranged obliquely from the first air deflector 114 to the bottom plate 116 toward the side close to the center of the storage cavity 12, so that an included angle A is formed between the first air deflector 114 and the second air deflector 115, where A ≥ 90°, thereby forming a triangular air return cavity 117 between the first air deflector 114 and the second air deflector 115, and the included angle A is distributed on the side close to the top plate 111.

There are two second side plates 113, so that the second side plates 113 are arranged opposite to each other. The top surfaces of the second side plates 113 are fixed to the bottom surfaces of the top plate 111 and the first air deflector 114 at the same time, and the bottom surfaces of the second side plates 113 are fixed to the top surface of the bottom plate 116. After the top plate 111, the first side plate 112, the second side plate 113, the first air deflector 114, the second air deflector 115 and the bottom plate 116 are assembled, the entire housing 11 covers the storage cavity 12, and the storage cavity 12 is formed inside the housing 11.

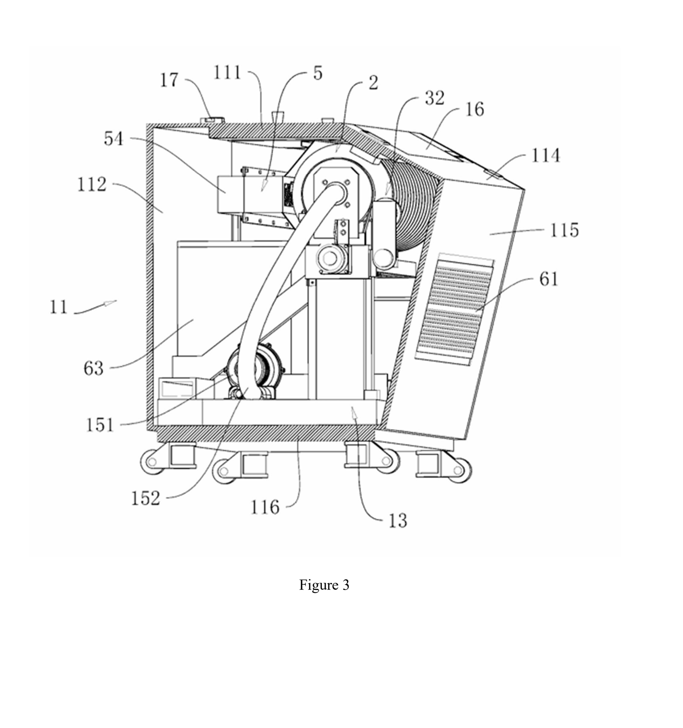

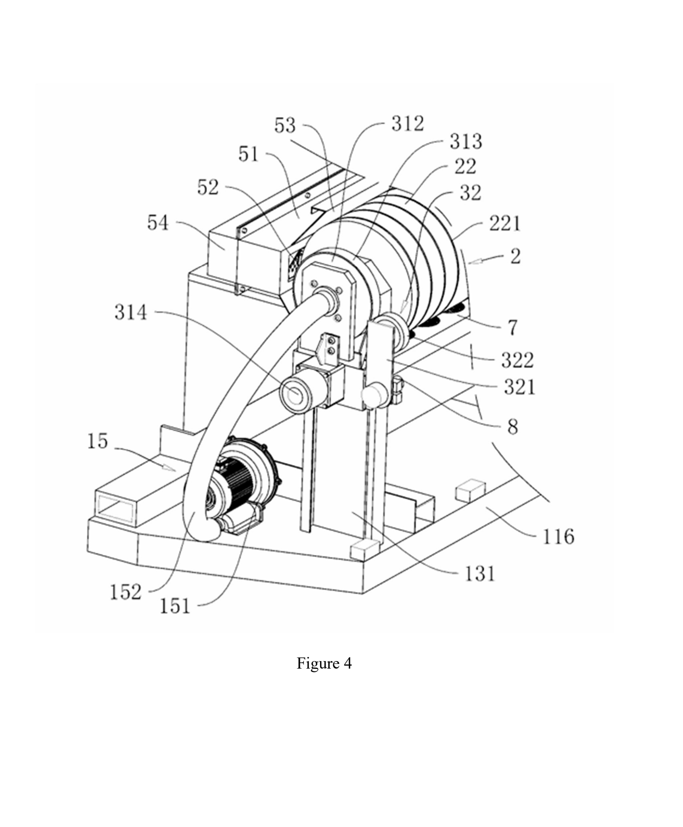

Referring to FIGS. 3 and 4, the exposure device further includes a mounting base frame 13, an exposure roller 2, a roller driving mechanism, a positioning mechanism 4 and an ultraviolet lamp 5. Wherein, the mounting base frame 13, the exposure roller 2, the roller driving mechanism, the positioning mechanism 4 and the ultraviolet lamp 5 are all disposed in the storage cavity 12. In the embodiment of the present disclosure, the mounting base frame 13 includes two brackets 131.

The two brackets 131 are arranged opposite to each other and vertically fixed on the top surface of the bottom plate 116, and an installation distance is left between the two brackets 131. The exposure roller 2 is disposed in the storage cavity 12, and two ends of the exposure roller 2 are rotatably connected to the two brackets 131 respectively, so that the axial direction of the exposure roller 2 is perpendicular to the extending direction of the brackets 131.

The roller driving mechanism is installed on the side wall of one of the brackets 131, so that the output end of the roller driving mechanism is assembled with one end of the exposure roller 2. The positioning mechanism 4 is rotatably installed on the mounting base frame 13, the extending direction of the positioning mechanism 4 is consistent with the length direction of the exposure roller 2, the flexible printing plate is wound and laid on the surface of the exposure roller 2, and one side of the positioning mechanism 4 is pressed against the surface of the flexible printing plate. Under the action of the positioning mechanism 4, the flexible printing plate can be fixed on the upper surface of the exposure roller 2.

In addition, the ultraviolet lamp 5 is installed on one side of the exposure roller 2, and the ultraviolet lamp 5 is aligned with the exposure roller 2. A control panel 16 and a control button 17 are disposed on the top surface of the top plate 111. The control button 17 is electrically connected to the control panel 16. Under the cooperative action of the control panel 16 and the control button 17, it is used to control the roller driving mechanism to drive the exposure roller 2 to rotate, thereby driving the flexible printing plate to move circumferentially, and also to control the light intensity and temperature of the ultraviolet lamp 5, so as to realize point-by-point and line-by-line exposure of the flexible printing plate.

Referring to FIGS. 2 and 3, an air exhaust part is disposed on the housing 11 near the lower part of the exposure roller 2. The air exhaust part includes an air exhaust plate 61, an air exhaust filter plate 62 and an air exhaust mechanism 63. Specifically, the air exhaust plate 61 is detachably embedded on the second air deflector 115 near the lower part of the exposure roller 2. The present disclosure does not limit the material of the air exhaust filter plate 62, but the air exhaust filter plate 62 at least needs to realize the function of filtering dust. The operator can select a filter screen made of synthetic fiber, non-woven fabric, glass fiber, activated carbon, sponge or nylon mesh according to the actual situation. The air exhaust filter plate 62 is fixed on one side of the air exhaust plate 61 close to the center of the storage cavity 12 by means of screw connection. The air exhaust mechanism 63 is fixed in the storage cavity 12. The air exhaust mechanism 63 is an exhaust fan used to exhaust the waste gas inside the storage cavity 12 to the outside of the housing 11. The mechanical structure and mechanical principle of the air exhaust mechanism 63 belong to the prior art, and will not be described in detail in the embodiment of the present disclosure.

Referring to FIG. 4, an air blowing mechanism 7 is fixed between the two brackets 131. The air blowing mechanism 7 is distributed at the bottom of the exposure roller 2. In the embodiment of the present disclosure, the air blowing mechanism 7 includes a plurality of blowing fans. The plurality of blowing fans are arranged at equal intervals and in a straight line. The output ends of the blowing fans are aligned with the outer wall of the exposure roller 2, and the connection line of the plurality of blowing fans is parallel to the central axis of the exposure roller 2 up and down.

When the ultraviolet lamp 5 exposes the flexible printing plate wound and laid on the surface of the exposure roller 2, a large amount of heat is generated around the exposure roller 2. After the heat contacts the air, hot air is generated, and the hot air rises. The operator starts the air exhaust mechanism 63 and the air blowing mechanism 7 at the same time. The blowing fans accelerate the rising speed of the hot air, prolong the residence time of the hot air at the included angle A of the triangular air return cavity 117, so that there will be no sudden cooling or sudden heating around the exposure roller 2, thereby controlling the temperature in the storage cavity 12 within a specified range value, reducing the difference in local ambient temperature caused by different working durations of the ultraviolet lamp 5, and helping to keep the temperature of the working environment of the flexible printing plate approximately constant. Under the action of the air exhaust mechanism 63, the part of the hot air is exhausted out of the housing 11 from the air exhaust plate 61, so as to achieve the effect of cooling the storage cavity 12 and ensure the imaging quality of the flexible printing plate.

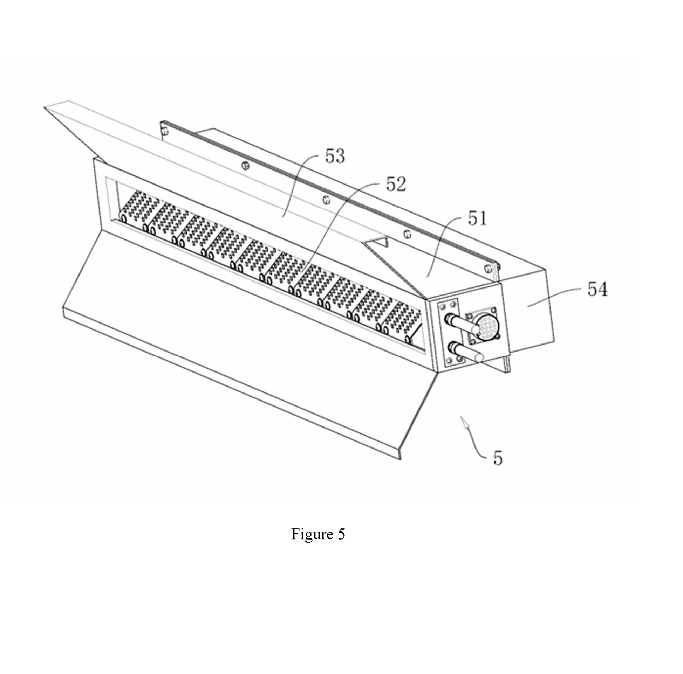

Referring to FIGS. 4 and 5, the ultraviolet lamp 5 includes a lamp holder 51 and a plurality of lamp panels 52. The lamp holder 51 is fixed between the two second side plates 113 by means of screw connection, so that the length center line of the lamp holder 51 is parallel to the center line of the exposure roller 2 left and right. In the embodiment of the present disclosure, the lamp holder 51 is distributed on the side close to the first side plate 112. The plurality of lamp panels 52 are arranged side by side on one side of the lamp holder 51 close to the exposure roller 2. The lamp panels 52 are detachably connected to the lamp holder 51. When one of the lamp panels 52 is damaged, the operator can replace the damaged lamp panel 52 individually to save production costs.

A horn-shaped lampshade 53 is disposed outside the ultraviolet lamp 5, and the opening direction of the lampshade 53 faces the exposure roller 2. The present disclosure does not limit the specific material of the lampshade 53, but requires the lampshade 53 to be opaque, and the side of the lampshade 53 close to the exposure roller 2 has the functions of concentrating light and reflecting light. In the embodiment of the present disclosure, the lampshade 53 is a metal lampshade 53, and the side of the lampshade 53 close to the exposure roller 2 is polished. When the ultraviolet lamp 5 irradiates the flexible printing plate, the lampshade 53 can play the role of concentrating light and temperature, so that the ultraviolet light emitted by the ultraviolet lamp 5 can be well irradiated to the flexible printing plate wound on the surface of the exposure roller 2. In addition, the ultraviolet light irradiated on the inner wall of the lampshade 53 is reflected to the surface of the flexible printing plate, further supplementing the light intensity to ensure the imaging quality of the flexible printing plate.

A cooling mechanism 54 is disposed on one side of the ultraviolet lamp 5 away from the exposure roller 2. The cooling mechanism 54 in the present disclosure may be an air-cooled condenser or a water-cooled condenser. Under the operation of the cooling mechanism 54, the ultraviolet lamp 5 can be cooled, the overheating phenomenon of the ultraviolet lamp 5 caused by too long working time is reduced, the ultraviolet lamp 5 emits an approximately constant temperature, and at the same time, helps to prolong the service life of the ultraviolet lamp 5.

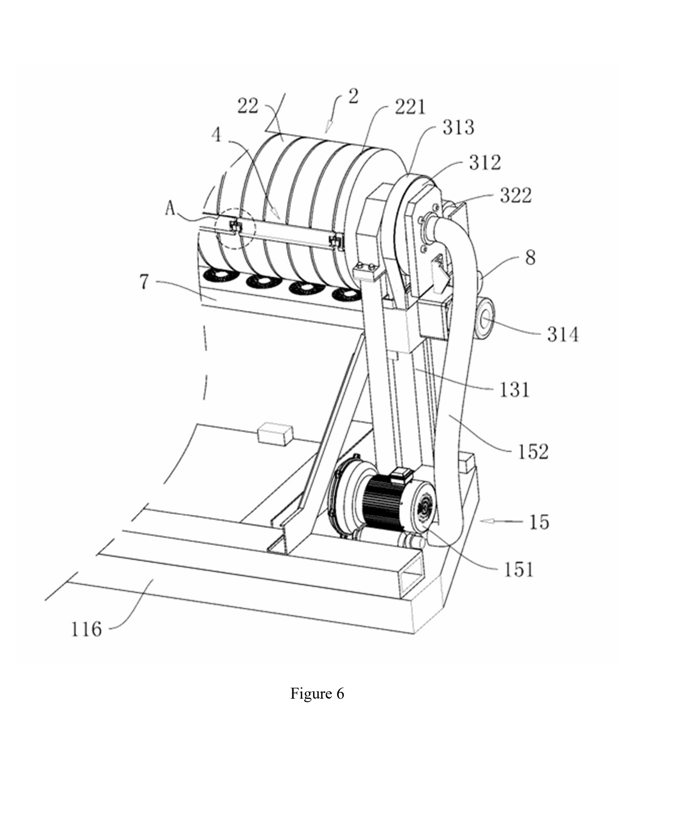

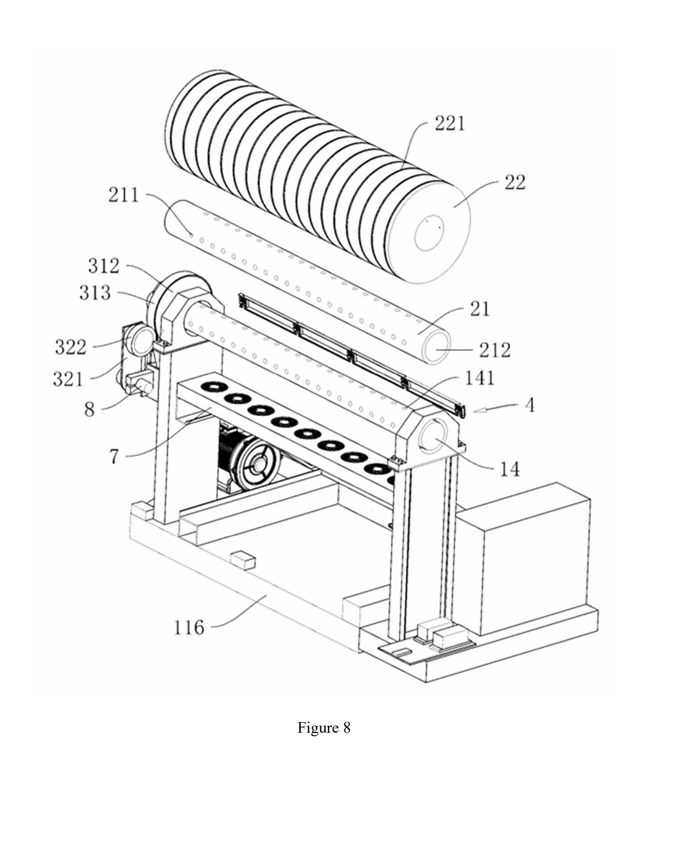

In order to realize the installation of the flexible printing plate, referring to FIGS. 6 and 8, the exposure roller 2 includes a central axis 21 and a roller body 22. The roller body 22 is fixed on the outer wall of the central axis 21. Both the roller body 22 and the central axis 21 are of circular shaft structure. A receiving groove 212 is formed through the central axis 21 along its axial direction. The central axis 21 has a plurality of ventilation holes 211. The plurality of ventilation holes 211 are uniformly distributed on the outer wall of the central axis 21, so that the ventilation holes 211 connect the outside with the internal receiving groove 212. The roller body 22 has a plurality of ventilation grooves 221. The ventilation grooves 221 are circular grooves or U-shaped grooves opened on the outer wall of the roller body 22, but U-shaped grooves are preferred. The length of the U-shaped ventilation groove 221 is seven-eighths of the circumference of the roller body 22, that is, an airtight area is left on the outer wall of the roller body 22. The plurality of ventilation grooves 221 are arranged at equal intervals along the length direction of the outer wall of the roller body 22, and the ventilation grooves 221 are connected to the ventilation holes 211 of the central axis 21.

More specifically, a suction air rod 14 is fixed between the two brackets 131. The suction air rod 14 is an air rod with one end open and the other end closed, and the interior of the suction air rod 14 is hollow. The suction air rod 14 is inserted in the receiving groove 212. The suction air rod 14 has a plurality of suction holes 141. The plurality of suction holes 141 are uniformly distributed on the outer wall of the suction air rod 14, and the suction holes are connected to the ventilation holes 211. A suction starting component 15 is disposed in the storage cavity 12. The suction starting component 15 is fixed on the top surface of the bottom plate 116. The output end of the suction starting component 15 is assembled with one end of the suction air rod 14. The suction starting component 15 includes a suction air pump 151 and a suction air pipe 152. One end of the suction air pipe 152 is connected to the output end of the suction air pump 151, and the other end is connected to the open end of the suction air rod 14.

When the ventilation groove 221 of the roller body 22 is a circular groove and the length dimension of the flexible printing plate is smaller than that of the roller body 22 (not shown in the figure), a part of the ventilation groove 221 of the roller body 22 is exposed outside the flexible printing plate. Under the action of the suction starting component 15, the gas in the suction air rod 14 can be extracted. Since part of the ventilation groove 221 is located outside the flexible printing plate, the external air is connected to the internal air of the suction air pipe 152. Part of the edge of the flexible printing plate fluctuates slightly under the influence of the air pressure difference, and the other parts of the flexible printing plate are tightly attached to the outer wall of the roller body 22 under the action of the negative pressure inside the suction air rod 14.

When the ventilation groove 221 of the roller body 22 is a U-shaped groove, the operator winds and lays the flexible printing plate on the exposure roller 2. The flexible printing plate completely covers the ventilation groove 221 of the roller body 22 and the ventilation hole 211 of the central axis 21. The air inside the suction air rod 14 cannot be connected to the external air. Under the action of the suction starting component 15, the gas in the suction air rod 14 can be extracted, so that the middle part of the exposure roller 2 always maintains a negative pressure state, thereby enabling the flexible printing plate to be stably attached to the surface of the roller body 22, which helps to solve the technical defect of the above-mentioned circular ventilation groove 221.

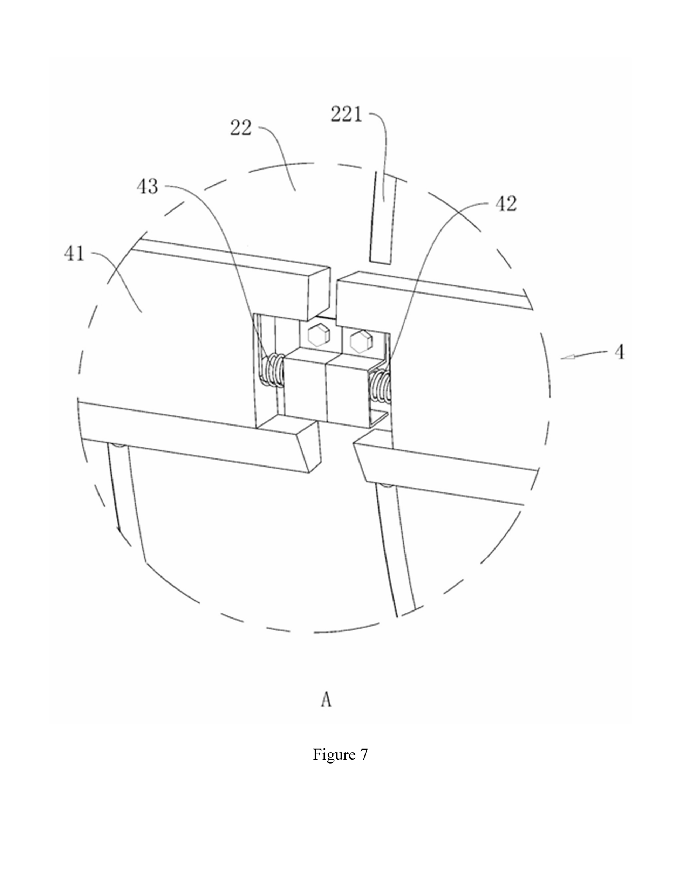

Referring to FIGS. 6 and 7, the positioning mechanism 4 is disposed between the two brackets 131, and the positioning mechanism 4 is distributed on one side of the airtight area. In the embodiment of the present disclosure, the positioning mechanism 4 includes a positioning rotating plate 41, a torsion spring 42 and a rotating shaft 43. Specifically, two ends of the rotating shaft 43 are rotatably connected to the two brackets 131 respectively. The positioning rotating plate 41 is disposed on the rotating shaft 43. The torsion spring 42 is sleeved on the outer wall of the rotating shaft 43, and one end of the torsion spring 42 is fixed to the positioning rotating plate 41, and the other end is fixed to the rotating shaft 43.

When the flexible printing plate is covered on the surface of the roller body 22, the positioning rotating plate 41 can compact the edge of one side of the flexible printing plate close to the positioning rotating plate 41 under the elastic force of the torsion spring 42. Under the cooperative action of the suction air rod 14 and the suction starting component 15, the installation of the flexible printing plate is realized. According to the actual operation situation, the operator can add adhesive tape to the edge part of the flexible printing plate to tightly attach the flexible printing plate to the roller body 22, thereby reducing the positional deviation of the flexible printing plate during the rotation of the exposure roller 2 and helping to improve the imaging quality of the printing plate.

Referring to FIGS. 6 and 8, the roller driving mechanism includes a power component and a deviation correcting member 32. The power component is installed on one of the brackets 131. The power component serves as a power source to drive the exposure roller 2 to rotate. The deviation correcting member 32 is rotatably connected to one side of the mounting base frame 13 close to the power component. The deviation correcting member 32 is used to correct the rotation trajectory of the exposure roller 2.

Specifically, the power component includes a first pulley (not shown in the figure), a second pulley 312, a transmission shaft (not shown in the figure), a transmission belt 313 and a transmission motor 314. Wherein, the transmission motor 314 is fixed on the side wall of the bracket 131. The transmission shaft is rotatably connected to the side wall of the bracket 131, and one end of the transmission shaft is assembled with the output end of the transmission motor 314. The first pulley is fixed on one end of the transmission shaft away from the transmission motor 314. The second pulley 312 is fixed on the end of the central axis 21 of the exposure roller 2. The transmission belt 313 is wound and engaged with the first pulley and the second pulley 312 at the same time.

More specifically, the deviation correcting member 32 includes a deviation correcting support 321, a deviation correcting connecting shaft and a deviation correcting wheel 322. Wherein, the deviation correcting support 321 is fixed on one side of the bracket 131 close to the transmission motor 314. The deviation correcting connecting shaft is rotatably connected to the deviation correcting support 321, so that the extending direction of the deviation correcting connecting shaft is consistent with the extending direction of the transmission shaft. The deviation correcting wheel 322 is fixed on the deviation correcting connecting shaft, and at the same time, the outer wall of the deviation correcting wheel 322 is in contact with the outer wall of the transmission belt 313. In the embodiment of the present disclosure, a temperature sensor 8 is further disposed on the side wall of the deviation correcting support 321.

Start the transmission motor 314, the transmission shaft can drive the first pulley to rotate. Synchronously, under the cooperative action of the transmission belt 313 and the second pulley 312, the central axis 21 can be driven to rotate, thereby driving the flexible printing plate wound and laid on the surface of the exposure roller 2 to move circumferentially. At the same time, the deviation correcting wheel 322 guides the transmission belt 313 and corrects the rotation trajectory of the exposure roller 2, so that the exposure roller 2 keeps moving on the same circumference. The temperature sensor 8 converts the ambient temperature signal into an electrical signal for output in real time, and feeds the electrical signal back to the power component. The power component controls the rotation of the exposure roller 2, thereby realizing automatic temperature adjustment, so that the flexible printing plate is always exposed within a specified temperature range, and the exposure quality is ensured.

Compared with the prior art, the present disclosure adopts a single-variable exposure method to perform one-way exposure on the flexible printing plate, omits the glass plate, and reduces the adverse effects of light environments of different media on the flexible printing plate; through the circumferential movement of the flexible printing plate, that is, the cooperation between the static ultraviolet lamp 5 and the dynamic flexible printing plate, dynamic balance can be achieved, so that each part of the flexible printing plate can be uniformly exposed, and the situation that the exposure time of the flexible printing plate is different due to the plane reciprocating movement of the ultraviolet lamp 5 is reduced, thereby achieving the purpose of improving the exposure quality of the flexible printing plate.

The above are all preferred embodiments of the present disclosure. This embodiment is only an explanation of the present disclosure, and is not intended to limit the protection scope of the present disclosure. Therefore: all equivalent changes made according to the structure, shape and principle of the present disclosure should be covered within the protection scope of the present disclosure.

## Claims

1. A Uniform Exposure apparatus for flexible printing plate, comprising:
a base, comprising a housing (11) and a storage cavity (12), the housing (11) covering the storage cavity (12);
an exposure roller (2), being disposed in the storage cavity (12), two ends of the exposure roller (2) being rotatably connected to two opposite inner sidewalls of the housing (11) respectively, and the flexible printing plate being wound and laid on a surface of the exposure roller (2);
a roller driving mechanism, being installed in the storage cavity (12), an output end of the roller driving mechanism being assembled with an end of the exposure roller (2), and the roller driving mechanism being configured to drive the exposure roller (2) to rotate;
a positioning mechanism (4), being rotatably installed in the storage cavity (12), and a side of the positioning mechanism (4) pressing against a surface of the flexible printing plate;
an ultraviolet lamp (5), being installed on a side of the exposure roller (2) and being aligned with the exposure roller (2);
an air exhaust part, disposed on the housing (11) adjacent to a lower part of the exposure roller (2);
wherein the housing (11) comprises a top plate (111), a first air deflector (114), a second air deflector (115) and a bottom plate (116); a side of the first air deflector (114) is fixed to the top plate (111) while another side is fixed to the second air deflector (115); a side of the second air deflector (115) away from the first air deflector (114) is fixed to the bottom plate (116); the first air deflector (114) is arranged obliquely downward from the top plate (111) to the second air deflector (115), the second air deflector (115) is arranged obliquely from the first air deflector (114) to the bottom plate (116) toward a side close to a center of the storage cavity (12), and a triangular air return cavity (117) is formed between the first air deflector (114) and the second air deflector (115).

2. The Uniform Exposure apparatus according to claim 1, wherein the air exhaust part comprises an air exhaust plate (61), an air exhaust filter plate (62) and an air exhaust mechanism (63), the air exhaust plate (61) is detachably embedded on the housing (11) near a lower part of the exposure roller (2), the air exhaust filter plate (62) is installed on a side of the air exhaust plate (61) close to the center of the storage cavity (12), the air exhaust mechanism (63) is fixed in the storage cavity (12) and is configured to exhaust waste gas inside the storage cavity (12).

3. The Uniform Exposure apparatus according to claim 1, further comprising a cooling mechanism (54) disposed on a side of the ultraviolet lamp (5) away from the exposure roller (2).

4. The Uniform Exposure apparatus according to claim 1, wherein a mounting base frame (13) is fixed in the storage cavity (12), a suction air rod (14) is fixed on the mounting base frame (13), a receiving groove (212) is formed through the central axis (21) of the exposure roller (2), the suction air rod (14) is inserted in the receiving groove (212), the suction starting component (15) is disposed in the storage cavity (12), and an output end of the suction starting component (15) is assembled with an end of the suction air rod (14).

5. The Uniform Exposure apparatus according to claim 4, wherein a horn-shaped lampshade (53) is disposed outside the ultraviolet lamp (5), and an opening direction of the lampshade (53) faces the exposure roller (2).

6. The Uniform Exposure apparatus according to claim 4, wherein the air blowing mechanism (7) is disposed on the mounting base frame (13), the air blowing mechanism (7) is distributed at a bottom of the exposure roller (2), and an output end of the air blowing mechanism (7) is aligned with an outer wall of the exposure roller (2).

7. The Uniform Exposure apparatus according to claim 4, wherein the roller driving mechanism comprises a power component and a deviation correcting member (32), the power component is installed on the mounting base frame (13), the power component serves as a power source to drive the exposure roller (2) to rotate, the deviation correcting member (32) is rotatably connected to a side of the mounting base frame (13) close to the power component, and the deviation correcting member (32) is configured to correct a rotation trajectory of the exposure roller (2).

8. The Uniform Exposure apparatus according to any of claims 4 to 7, further comprises a temperature sensor (8) disposed on the mounting base frame (13).
